# EUROPÄISCHE PATENTSCHRIFT

(11) **EP 2 033 313 B1**
(45) Veröffentlichungstag und Bekanntmachung des Hinweises auf die Patenterteilung: **10.08.2011**
(21) Anmeldenummer: 07724404.4
(22) Anmeldetag: 20.04.2007
(51) Int. Cl.: H03K 17/955, H03K 17/96, E05F 15/00

(54) **EINKLEMMSENSOR**
ANTI-PINCH SENSOR
CAPTEUR DE SERRAGE

(30) Priorität: 12.06.2006 DE 202006009188 U
(43) Veröffentlichungstag der Anmeldung: 11.03.2009
(73) Patentinhaber: Brose Fahrzeugteile GmbH & Co. Kommanditgesellschaft Coburg, 96450 Coburg (DE)
(72) Erfinder: ABERT, Carsten, 97437 Haßfurt (DE); WEINGÄRTNER, Thomas, 97508 Untereuerheim (DE); MÜLLER, Wolf-Christian, 69123 Heidelberg (DE); WÜRSTLEIN, Holger, 97475 Zeil am Main (DE)
(74) Vertreter: FDST Patentanwälte
(86) Internationale Anmeldenummer: PCT/EP2007/003467
(87) Internationale Veröffentlichungsnummer: WO 2007/144039

(56) Entgegenhaltungen:
- EP-A- 1 277 907
- WO-A-89/08352
- WO-A-97/01835
- DE-A1- 4 006 119
- US-A1- 2003 085 679
- US-A1- 2005 016 290
- US-A1- 2006 117 862
- US-B1- 6 747 399

## Beschreibung

Die Erfindung betrifft einen Einklemmsensor, insbesondere zum Erkennen eines Hindernisses im Weg eines Stellelements eines Kraftfahrzeugs.

Bekannte Einklemmsensoren nutzen zum Erkennen eines Hindernisses beispielsweise das kapazitive Messprinzip. Dabei wird zwischen einer Messelektrode und einer geeigneten Gegenelektrode ein elektrisches Feld aufgebaut. Tritt in dieses elektrische Feld ein Dielektrikum ein, so verändert sich die Kapazität des von der Messelektrode und der Gegenelektrode gebildeten Kondensators. Auf diese Weise kann theoretisch jedes Hindernis im Weg eines Stellelements eines Kraftfahrzeugs detektiert werden, dessen relative Dielektrizitätszahl εᵣ sich von der relativen Dielektrizitätszahl von Luft unterscheidet. Das Hindernis im Weg eines Stellelements wird ohne einen physischen Kontakt mit dem Einklemmsensor erkannt. Wird eine Kapazitätsänderung detektiert, so können rechtzeitig Gegenmaßnahmen, wie beispielsweise ein Stoppen oder ein Reversieren des Antriebs eingeleitet werden, bevor es zu einem tatsächlichen Einklemmen des Hindernisses kommt.

Bei den Stellelementen eines Kraftfahrzeuges kann es sich beispielsweise um ein elektrisch betätigbares Fenster, eine elektrisch betätigbare Schiebetür oder eine elektrisch betätigbare Heckklappe handeln. Auch kann ein auf dem kapazitiven Messprinzip beruhender Einklemmsensor zur Detektion von Hindernissen im Falle eines elektrisch betätigbaren Sitzes eingesetzt werden.

Berührungslos arbeitende, auf dem kapazitiven Messprinzip beruhende Einklemmsensoren sind beispielsweise aus der US 2006/0117862, der EP 1 455 044 A2 und der EP 1 154 110 A2 bekannt. Die Sensoren erzeugen mittels einer Messelektrode und einer geeigneten Gegenelektrode ein äußeres elektrisches Feld, so dass ein in dieses äußere elektrische Feld eindringendes Dielektrikum als eine Kapazitätsänderung zwischen Messelektrode und Gegenelektrode detektiert werden kann. Um eine hohe Sicherheit bei der Detektion eines Einklemmfalles gewährleisten zu können, ist zusätzlich bei beiden vorbekannten Einklemmsensoren der Abstand zwischen Messelektrode und Gegenelektrode flexibel gestaltet, wodurch auch ein physischer Kontakt eines Hindernisses mit dem Einklemmsensor als eine Kapazitätsänderung detektierbar wird.

Gemäß der EP 1 455 044 A2 werden hierzu die Messelektrode und die Gegenelektrode in einem Sensorkörper aus einem elastischen Isoliermaterial durch eine materialfreie Blase voneinander getrennt. In der EP 1 154 110 A2 wird hierzu vorgeschlagen, in einem Sensorkörper aus einem Isoliermaterial zwischen Messelektrode und Gegenelektrode einen Materialbereich mit einer gegenüber dem übrigen Isoliermaterial verminderten Härte vorzusehen. Auch dieser Materialbereich kann als eine materialfreie Blase ausgestaltet sein.

Nachteiligerweise zeigen die Einklemmsensoren des Standes der Technik eine hohe Empfindlichkeit gegenüber äußeren elektromagnetischen Störfeldern. Dies erschwert eine Auswertung der Sensorsignale bei Annäherung von Mess- und Gegenelektrode. Weiter kann es nachteiligerweise bei den beiden letztgenannten Einklemmsensoren zu einem Verkleben zwischen Mess- und Gegenelektrode kommen, was zumindest einen Teilausfall des Einklemmsensors bedeutet.

Aufgabe der Erfindung ist es, einen Einklemmsensor anzugeben, der eine möglichst hohe Sicherheit bei der Detektion eines Einklemmfalles im Weg eines Stellelements eines Kraftfahrzeugs bietet. Weiter ist es Aufgabe der Erfindung, eine für einen derartigen Einklemmsensor geeignete Auswerteschaltung anzugeben.

Diese Aufgabe wird erfindungsgemäß durch die Merkmalskombination des Anspruchs 1 gelöst.

Die Erfindung sowie die US 2006/0117862 geht dabei in einem ersten Schritt von der Überlegung aus, dass ein Hindernis im Weg eines Stellelements mit den eingangs genannten Einklemmsensoren gemäß Stand der Technik zwar sowohl berührungslos bei Annäherung als auch bei physischem Kontakt detektiert wird, dass jedoch die beiden letztgenannten bekannten Einklemmsensoren im eigentlichen Sinne nicht redundant arbeiten, da sowohl für die berührungslose als auch für die taktile Detektion ein- und dieselben Komponenten verwendet werden. Die Kapazität zwischen einer Messelektrode und einer Gegenelektrode wird sowohl hinsichtlich ihrer Abhängigkeit von einem eindringenden Dielektrikum als auch hinsichtlich ihrer Abhängigkeit vom Elektrodenabstand ausgewertet. Dies führt jedoch dazu, dass ein Ausfall eines Teilsystems gleichbedeutend ist mit einem Ausfall des Gesamtsystems. Verkleben beispielsweise die Messelektrode und die Gegenelektrode miteinander oder dringt Flüssigkeit zwischen die Messelektrode und die Gegenelektrode, so kann die zwischen den Elektroden gebildete Kapazität nicht mehr zu einer berührungslosen Detektion eines eindringenden Dielektrikums herangezogen werden.

Diese Problematik löst die Erfindung und die US2006/0117862 dadurch, dass zur Detektion eines physischen Kontaktes ein Drucksensor vorgesehen ist, der von der Messelektrode zur Erzeugung eines äußeren elektrischen Feldes entkoppelt ist. Somit kann selbst bei einem Totalausfall der Messelektrode, die zur berührungslosen Detektion eines Hindernisses notwendig ist, nach wie vor der physische Kontakt eines Hindernisses mit dem Einklemmsensor detektiert und sofortige Gegenmaßnahmen eingeleitet werden. Dies erhöht die Sicherheit für die Detektion eines Einklemmfalles gegenüber den anderen bekannten Einklemmsensoren beträchtlich.

Neben der Erhöhung der Sicherheit bei Erkennung eines Einklemmfalles bietet die Erfindung und die US2006/0117862 den weiteren Vorteil, dass sich der Drucksensor und die Messelektrode völlig unabhängig voneinander und daher insbesondere parallel auswerten lassen. Die gekoppelten Teilsysteme der bekannten Einklemmsensoren können im Gegensatz hierzu, da für beide Teilsysteme dieselben Komponenten verwendet werden, nur seriell ausgewertet werden, womit immer eine unerwünschte Zeitverzögerung verbunden ist.

Zur Ausgestaltung des Einklemmsensors ist es nicht notwendig, dass der Sensorkörper aus einem elastischen Material besteht. Denn der separate, von der zum Aufbau einer Messkapazität vorgesehenen Messelektrode im Hinblick auf die Detektion entkoppelte Drucksensor kann insbesondere an einer exponierten Stelle angeordnet sein, die eine Detektion einer äußeren Kraft- bzw. Druckeinwirkung ermöglicht. So kann der Drucksensor beispielsweise auf oder unter der Oberfläche des Einklemmsensors angeordnet sein.

Für die Anwendung des Einklemmsensors im Automobilbereich ist es jedoch sinnvoll, wenn der Sensorkörper aus einem flexiblen, insbesondere elastischen Material besteht. Hierdurch wird es ermöglicht, den Einklemmsensor beispielsweise entlang der Schließkante eines Stellelements zu führen und ihn hierbei entsprechend der vorgegebenen Geometrien zu verformen. Auch erlaubt es eine elastische Ausgestaltung des Sensorkörpers, den Drucksensor im Inneren des Einklemmsensors anzuordnen.

Doch auch im Falle eines elastischen Sensorkörpers stellt es eine einfache und kostengünstige Möglichkeit dar, den Drucksensor als ein Kontaktelement dem Sensorkörper aufzulegen. Vorteilhafterweise ist der Drucksensor dabei an einer Auflagefläche des Sensorkörpers angeordnet. Hierdurch kann eine zusätzliche Abschirmung der Messelektrode erreicht werden, was sich günstig auf die Störempfindlichkeit gegen äußere Felder auswirkt. Auch bei einem elastischen Material des Sensorkörpers kann ein physischer Kontakt eines Hindernisses mit dem Einklemmsensor durch eine entsprechende Verformung des Drucksensors detektiert werden.

Dadurch, dass der Sensorkörper einen Drucksensorteil aus einem flexiblen, insbesondere elastischen Material und einen Messelektrodenteil aus einem Material höherer Härte umfasst, hat eine Druckverformung des im Drucksensorteil eingebetteten Drucksensors keinen Einfluss auf die Kapazität zwischen Mess- und Gegenelektrode, da sich deren Abstand hierdurch nicht oder nur vernachlässigbar ändert. Als Material des Drucksensorteils bietet sich beispielsweise EPDM an. Für das Material des Messelektrodenteils kann beispielsweise ein aushärtendes Kunstharz oder ein Hartkunststoff eingesetzt werden.

Für die bereits erwähnte Führung des Einklemmsensors entlang einer Schließkante eines Stellelements ist es zweckmäßig, wenn sich der Sensorkörper in einer Längsrichtung erstreckt, wobei die Messelektrode als Flachleiter ausgeführt ist. Neben den Verwendungs- und Einbauvorteilen einer derartigen Form kann ein solch langgestreckter Einklemmsensor auch kostengünstig mittels Extrusion hergestellt werden.

Insbesondere bietet es sich an, den Sensorkörper als einen Dichtkörper mit einer Dichtkontur auszugestalten. Hierdurch wird es ermöglicht, den Einklemmsensor gleichsam als Dichtung entlang der Schließkante der Karosserie, z.B. als Tür- oder Fenstergummi, zur Abdichtung gegenüber dem Schließelement zu verlegen.

In einer weiteren vorteilhaften Ausgestaltung der Erfindung ist die Messelektrode entlang der Längsrichtung in eine Anzahl von Einzelelektroden unterteilt, die jeweils über eine separate Zuleitung kontaktierbar sind. Hierdurch wird erreicht, dass sich die zwischen der Messelektrode und der Gegenelektrode messbare Kapazität verringert, da die gesamte Fläche der Messelektrode in mehrere unterbrochene Einzelflächen der getrennten Elektroden aufgeteilt ist. Eine niedrige, sich insgesamt zwischen Mess- und Gegenelektrode ausbildende Kapazität führt jedoch dazu, dass sich eine kleine Kapazitätsänderung im Verhältnis zur Gesamtkapazität leichter detektieren lässt. Das Verhältnis aus Kapazitätsänderung und Gesamtkapazität verschiebt sich zugunsten der Kapazitätsänderung. Ein derart ausgestalteter Einklemmsensor erlaubt zudem die Detektion einer Kapazitätsänderung mittels eines Multiplex-Verfahrens. Dabei können die einzelnen Elektroden mittels der separaten Zuleitungen entweder zeitlich versetzt (seriell) oder gleichzeitig (parallel) angesteuert werden. Eine serielle Ansteuerung bietet den Vorteil, dass nur eine einzige Auswerteschaltung zur Detektion einer Kapazitätsänderung notwendig wird. Allerdings ist hierbei die Zeitkonstante zu beachten, bis alle Einzelelektroden nacheinander durchgeschaltet worden sind. Eine parallele Ansteuerung weist zwar die nachteilige Zeitverzögerung nicht auf, erfordert jedoch zur Auswertung mehrere Auswerteelektroniken, wodurch sich die Kosten erhöhen.

Die Unterteilung der Messelektrode in eine Anzahl von Einzelelektroden bietet den Vorteil einer ortsaufgelösten Detektion eines Einklemmfalles. Insofern ist es zweckmäßig, wenn auch der Drucksensor entlang der Längsrichtung in eine Anzahl von getrennt auslesbaren Einzelsensoren segmentiert ist. Ein Einklemmsensor mit einer derartigen Segmentation sowohl der Messelektrode als auch des Drucksensors erlaubt es zudem, in unterschiedlichen Segmenten eine unterschiedliche Priorisierung von Kapazitätsund Drucksensorsignalen vorzusehen. So kann beispielsweise im Scherspalt einer Heckklappe in unmittelbarer Nähe des Drehpunktes bzw. der drehbaren Heckklappenlagerung die berührungslose Detektion eines Hindernisses mittels einer Kapazitätsänderung zugunsten der taktilen Detektion ausgeschaltet werden. Denn im Bereich der Lagerung sind die Heckklappe und die Kraftfahrzeugkarosserie dicht beabstandet, so dass sich mittels einer Messelektrode gegenüber der Karosserie als Gegenelektrode kein elektrisches Fernfeld ausbilden lässt. Vielmehr wird sich eine direkte Kapazität zwischen der Messelektrode und der benachbarten Heckklappe bzw. zwischen der Messelektrode und dem Rahmen bei einer Anordnung des Einklemmsensors an der Heckklappe ausbilden. Insofern kann dort der Detektion eines Einklemmfalles mittels physischem Kontakt der Vorzug gegenüber der berührungslosen Detektion eingeräumt werden.

Für die Ausbildung eines elektrischen Fernfeldes zwischen Messelektrode und Gegenelektrode ist es weiter vorteilhaft, wenn der Sensorkörper eine als Driven-Shield ausgebildete oder schaltbare Abschirmelektrode umfasst Die als Driven-Shield eingesetzte Abschirmelektrode:, welche beider Erfingdung durch eine Elektrode des Drucksensors realisiert ist, wird dabei durch geeignete Schaltmittel auf dasselbe Potenzial wie die Messelektrode gebracht. Auf diese Weise wird zwischen der Messelektrode und der Gegenelektrode keine direkte Kapazität ausgebildet. Vielmehr bildet sich zwischen der Messelektrode und der durch die Elektrode des Drucksensors abgeschirmten Gegenelektrode ein räumlich ausgedehntes elektrisches Feld, so dass ein eindringendes Dielektrikum berührungslos durch eine Kapazitätsänderung erfasst werden kann. Insbesondere bietet es sich dabei an, als Gegenelektrode die Karosserie und insbesondere den Rahmen der Karosserie zu verwenden, in welchem das Stellelement geführt ist. Dabei ist die Driven-Shield-Elektrode vorzugsweise so anzuordnen, dass sich das zwischen Mess-und Gegenelektrode ausbildende elektrische Feld in den potentiellen Gefährdungsbereich hinein erstreckt. Dies kann beispielsweise dadurch verwirklicht werden, dass die als Driven-Shield-Elektrode betriebene Elektrode des Drucksensors im Wesentlichen der Messelektrode gegenüberliegt bzw. zwischen dieser und der Gegenelektrode angeordnet ist.

Für die Ausgestaltung, in welcher die Messelektrode in Einzelelektroden segmentiert ist, ist es zweckmäßig, wenn die Abschirmelektrode in elektrisch kontaktierbare Einzelelektroden unterteilt ist, zwischen denen isoliert die separaten Zuleitungen angeordnet sind. Auf diese Weise wird auch verhindert, dass sich zwischen den Zuleitungen und der Gegenelektrode eine direkte Kapazität ausbildet.

Für den Drucksensor selbst eignen sich prinzipiell alle bekannten Drucksensortypen: mit Elektrode. So kann ein druckabhängiger Widerstand ebenso eingesetzt werden wie eine druckab-hängige Kapazität. Insbesondere können auch so genannte Dehnmessstreifen verwendet werden, deren Widerstandsänderung bei einer mechanischen Ausdehnung oder Stauchung messtechnisch erfasst werden kann. Auch ist es möglich, als einen Drucksensor einen Hall-Sensor einzusetzen, wobei sich unter einer Druckbelastung ein Magnetfeld um den Hall-Sensor ändert. Um jedoch die Empfindlichkeit des Einklemmsensors gegenüber äußeren Störfeldern möglichst gering zu halten, bietet es sich an, als Drucksensor einen piezoelektrischen Drucksensor zu verwenden. Dabei wird mittels eines geeigneten Piezoelektreten der piezoelektrische Effekt ausgenutzt, wobei der geeignete Piezoelektret unter Druckeinwirkung eine elektrische Spannung generiert. Als ein Piezoelektret bietet sich eine Piezokeramik an, die insbesondere auch als piezokeramische Folie ausgebildet sein kann. Auch sind piezoelektrische Polymere bekannt. Die erzeugte Spannung wird mittels der Elektroden abgegriffen, zwischen denen der Piezoelektret bzw. die Piezokeramik angeordnet ist.

In einer besonders vorteilhaften Ausgestaltung ist als Drucksensor ein Piezoelektret eingesetzt, dessen unter Druck generierte elektrische Spannung mittels Elektroden abgegriffen wird, wobei eine dieser Elektroden erfingdungsgemäß als eine Abschirmelektrode des Driven-Shield verwendet wird. Hierdurch kann ein kompakter Aufbau des Einklemmsensors erzielt werden.

Der Einklemmsensor lässt sich sowohl als Flach- als auch als Rundkabel realisieren. Auch bietet es sich an, den Einklemmsensor in eine umlaufende Dichtung am Rahmen des Schließelements zu integrieren. Vorzugsweise ist der Einklemmsensor als flexible Leiterstruktur, beispielsweise als ein flexibles Flachkabel (FFC, flexible flat cable) ocer als eine flexible Leiterstruktur (FPC, flexible printed circuit) ausgeführt. Vorteilhafterweise sind dabei die einzelnen Elektroden jeweils als flache Leiterbahnen in dem flexiblen isolierenden Material der Leiterstruktur ausgebildet.

Eine geeignete Auswerteschaltung für den vorbeschriebenen Einklemmsensor umfasst Messpotenzialausgabemittel zur Ausgabe eines Messpotenzials an eine Messelektrode, Kapazitätserfassungsmittel zur Erfassung einer von einer Gegenelektrode und einer Messelektrode gebildeten Messkapazität, Kapazitätsauswertemittel zur Auswertung einer Änderung der erfassten Messkapazität, Sensorauswertemittel zur unabhängigen Erfassung und Auswertung von Signalen eines Drucksensors mit Elektroden und Ausgabemittel zur Ausgabe eines Detektionssignals in Abhängigkeit von der zeitlichen Änderung der Messkapazität und zur Ausgabe eines Detektionssignals in Abhängigkeit von dem ausgewerteten Signal des Drucksensors.

Die Messpotenzialausgabemittel sind zur Ausgabe eines geeigneten Messpotenzials bzw. zur Erzeugung einer entsprechenden Spannung an die Messelektrode bzw. zwischen der Messelektrode und der Gegenelektrode ausgestaltet. Die von Gegenelektrode und Messelektrode gebildete Messkapazität kann dann bei einer Gleichspannung beispielsweise über eine Lade- bzw. Entladezeit detektiert werden. Auch ist es möglich, die Messkapazität aus der Resonanzfrequenz eines Schwingkreises abzuleiten.

In einer messtechnisch einfachen und wenig störanfälligen Variante umfassen die Messpotenzialausgabemittel eine Wechselspannungsquelle. Dies erlaubt insbesondere zur Erfassung der Messkapazität eine Brückenschaltung vorzusehen, wobei die Messkapazität über ihren Wechselstromwiderstand oder über ihre Phasenwirkung bestimmt werden kann. Dabei wird die Messkapazität über die an ihr abfallende Spannung bei einer vorgegebenen Wechselspannung erfasst, wozu beispielsweise aus der abgegriffenen Spannung ein Spitzenwertsignal generiert wird, welches mit einer Vergleichsspannung verglichen werden kann. Alternativ ist es möglich, die aus der Kapazität im Wechselspiel mit einem Vorwiderstand resultierende Phasenverstimmung gegenüber der angelegten Wechselspannung zu detektieren.

Um eine Fehldetektion eines Einklemmfalles bei einem langsamen Driften der aus Messelektrode und Gegenelektrode gebildeten Kapazität zu vermeiden, können insbesondere steuerbare Kapazitäten zur Kompensation vorgesehen sein. Als steuerbare Kapazitäten können beispielsweise Kapazitätsdioden eingesetzt werden.

Die Sensorauswertemittel der Auswerteschaltung sind zur unabhängigen Erfassung und Auswertung von Signalen eines Drucksensor mit Elektroden ausgebildet. Hierdurch wird eine redundante Erfassung eines Hindernisses im Weg eines Stellelements ermöglicht, wobei das Hindernis zum einen berührungslos über die Kapazitätsänderung zwischen Messelektrode und Gegenelektrode erfasst und zum anderen bei einem weiteren Schließvorgang des Stellelements durch eine Kraft- bzw. Druckbeaufschlagung des Drucksensors erkannt wird.

In einer vorteilhaften Ausgestaltung sind die Kapazitätserfassungs- und -auswertemittel und/oder die Sensorauswertemittel zur selektiven Auswertung von in Segmenten angeordneten Einzelelektroden und/oder Einzelsensoren ausgebildet. Dies erlaubt mittels Multiplexing eine Ortsauflösung eines erkannten Einklemmfalles.

Dabei können - wie bereits erwähnt - die Ausgabemittel derart ausgelegt werden, dass zur Ausgabe des Detektionssignals die Signale der Einzelelektroden und der Einzelsensoren in unterschiedlichen Segmenten des Einklemmsensors unterschiedlich priorisiert werden. Dies ist beispielsweise bei einem Einsatz des Einklemmsensors im Scherspalt einer Heckklappe von Nutzen.

Zur Erfassung der Messkapazität oder der Signale des Drucksensors ist weiet von Vorteil, hierfür geeignete selektive Filter, wie beispielsweise einen Bandpaß vorzusehen. Hierdurch kann die Messempfindlichkeit erhöht werden.

Die Verwendung der vorbeschriebenen Auswerteschaltung, des vorbeschriebenen Einklemmsensors oder einer Baueinheit, die sowohl den Einklemmsensor als auch die Auswerteschaltung umfasst, bietet sich insbesondere in einem Kraftfahrzeug an, wobei als Gegenelektrode die geerdete Karosserie des Kraftfahrzeugs dient. Selbstverständlich ist es jedoch auch möglich, eine Gegenelektrode, die mit der Messelektrode eine Kapazität ausbildet, im Sensorkörper des Einklemmsensors anzuordnen.

Die nachfolgen den beispeilhaften Zeichunngen zeigen:
- Fig. 1: schematisch eine Seitenansicht eines Kraftfahrzeugs,
- Fig. 2: in einem Querschnitt einen durch eine flexible Leiterkarte realisierten Ein- klemmsensor,
- Fig. 2b: in einer Aufsicht einen alternativen Einklemmsensor,
- Fig. 3: in einem Querschnitt einen weiteren als Flachbandkabel realisierten Ein- klemmsensor,
- Fig. 4: in einem Querschnitt einen als Flachbandkabel ausgestal- teten erfingdungsgemäßen Einklemmsensor und
- Fig. 5: schematisch eine Auswerteschaltung

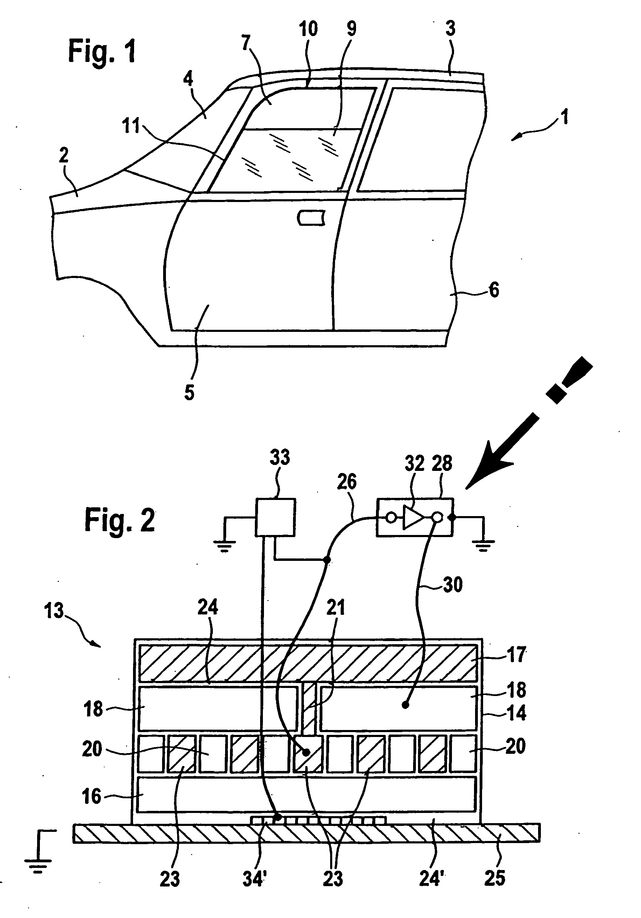

Fig. 1 zeigt schematisch eine Seitenansicht eines Kraftfahrzeugs 1, von dem die Motorhaube 2, das Dach 3 sowie die Windschutzscheibe 4 sichtbar sind. Weiter sind eine vordere Tür 5 und eine hintere Tür 6 dargestellt.

Die vordere Tür 5 weist als Stellelement 7 eine elektrisch angetriebene Scheibe 9 auf. Beim Schließen der Scheibe 9 muss sichergestellt werden, dass sich in der Bewegungssphäre der Scheibe 9 kein Hindernis befindet. Zu diesem Zweck ist entlang der vorderen und oberen Innenkontur der Tür 5 ein Einklemmsensor 10 angebracht, der durch ein Dichtelement 11 realisiert ist. In dem Dichtelement 11 befinden sich - hier nicht dargestellt - zur Ausbildung einer Messelektrode mehrere voneinander getrennte Einzelelektroden, die zur Ansteuerung separate Zuleitungen aufweisen. Zwischen den einzelnen Elektroden und der Innenkontur der vorderen Tür 5 ist in der Abdichtung 11 weiter eine Abschirmelektrode angeordnet. Als Gegenelektrode dient die Karosserie des Kraftfahrzeugs 1.

Die Abdichtung 11 umfasst einen Sensorkörper aus einem elastischen Kunststoff. Entlang der Abdichtung 11 sind in die Oberfläche des Sensorkörpers eine Reihe von druckempfindlichen Einzelsensoren eingelassen. Durch Auswertung der Signale der Einzelsensoren ist es möglich, ein physisch von der Scheibe 9 gegen die Abdichtung 11 drückendes Hindernis zu lokalisieren und entsprechende Gegenmaßnahmen wie ein sofortiges Stoppen und anschließendes Reversieren des Antriebs einzuleiten.

Vor Erreichen eines physischen Kontaktes mit der Abdichtung 11 wird mit dem Einklemmsensor 10 ein sich in der Bewegungssphäre der Scheibe 9 befindliches Hindernis, welches eine relative Dielektrizitätskonstante von > 1 aufweist, von dem Einklemmsensor 10 jedoch bereits berührungslos detektiert. Hierzu wird mittels eines an die Messelektrode angelegten Messpotenzials zwischen der Mess- und der Gegenelektrode ein elektrisches Feld erzeugt, welches aufgrund der vorhandenen Abschirmelektrode in den Raum hineinragt. Dringt ein dielektrisches Hindernis in dieses äußere elektrische Feld ein, so resultiert hieraus eine Änderung der aus den in der Abdichtung 11 angeordneten Elektroden und der als Gegenelektrode wirkenden Karosserie gebildeten Kapazität. Wird eine derartige Kapazitätsänderung detektiert, so wird ebenfalls mittels eines entsprechenden Steuersignals der elektrische Antrieb angehalten und reversierend angetrieben, d.h. in Gegenrichtung bestromt.

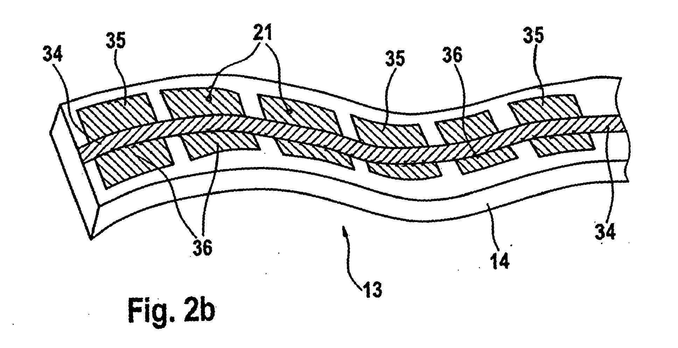

Zur Beschreibung der Funktionsweise ist in Fig. 2 ein weiterer Einklemmsensor 13 dargestellt, der durch eine mehrere Lagen aufweisende flexible Leiterstruktur 14 ausgestaltet ist. Die untere Lage der flexiblen Leiterstruktur 14 wird dabei durch eine als flächige Leiterbahn ausgebildete Abschirmelektrode 16 gebildet. Ihr gegenüber ist in der obersten Lage der Leiterkarte 14 als Messelektrode 17 weiter eine flächige Leiterbahn angeordnet. Diese ist - hier nicht sichtbar - in Längsrichtung der Leiterkarte 14 mehrfach unterteilt. Unterhalb der Messelektrode 17 ist wiederum als eine flächige Leiterbahn eine der Abschirmung dienende Einzelelektrode 18 ausgebildet, die mit der Abschirmelektrode 16 elektrisch leitend verbunden ist. In der Lage zwischen der Einzelelektrode 18 und der Abschirmelektrode 16 sind nun abwechselnd jeweils weitere der Abschirmung dienende Einzelelektroden 20 sowie separate elektrische Zuleitungen 23 angeordnet, die zur Kontaktierung der durch Segmentierung der Messelektrode 17 entstehenden Einzelelektroden dienen. In dem dargestellten Schnitt wird dies dadurch erkennbar, dass die mittig angeordnete elektrische Zuleitung 23 über eine Durchkontaktierung 21 mit der darüber angeordneten einzelnen Messelektrode 17 elektrisch kontaktiert ist. Zur Durchkontaktierung weist dabei die Einzelelektrode 18 an entsprechender Stelle einen Durchbruch auf. Die Elektroden sind jeweils voneinander durch ein flexibles Isolationsmaterial 24 der Leiterkarte 14 isoliert.

Zur Detektion eines Hindernisses im Weg eines Stellelements ist der Einklemmsensor 13 einer geerdeten Gegenelektrode 25 aufgesetzt, die beispielsweise durch die Karosserie eines Kraftfahrzeugs gebildet sein kann. Zum Messen einer durch ein Hindernis hervorgerufenen Kapazitätsänderung wird die Messelektrode 17 mittels der Signalleitung 26, der entsprechenden Zuleitung 23 sowie der Durchkontaktierung 21 mit einer Wechselspannung beaufschlagt. Die Wechselspannung wird hierbei durch einen Signalgenerator 28 gegenüber dem Erdpotenzial erzeugt. Weiter werden mittels der Verbindungsleitung 30 die der Abschirmung dienenden Einzelelektroden 18 und 20 sowie die Abschirmelektrode 16 mit einer Wechselspannung beaufschlagt, die aus der der Messelektrode 17 zugeleiteten Wechselspannung abgeleitet ist. Hierfür ist zwischen der Signalleitung 26 und der Verbindungsleitung 30 ein als Operationsverstärker ausgebildetes Schaltmittel 32 eingesetzt. Auf diese Weise wird sichergestellt, dass die der Abschirmung dienenden Elektroden 16,18 und 20 sich ohne zeitliche Verzögerung auf demselben Potenzial befinden wie die Messelektrode 17. Infolge der sich auf gleichem Potenzial befindlichen Einzelelektroden 16,18 und 20 bildet sich zwischen der Messelektrode 17 und der Gegenelektrode 25 keine direkte Kapazität. Diese wird direkt von der Abschirmelektrode 16 und der Gegenelektrode 25 gebildet. Stattdessen entsteht zwischen den Kanten der Messelektrode 17 und der Gegenelektrode bzw. der geerdeten Karosserie 25 ein in den Raum hinausragendes elektrisches Feld, dessen erfasster Raum zur Detektion von Hindernissen verfügbar wird. Dabei ist die durch die Kanten der Messelektrode 17 und der Gegenelektrode 25 gebildete Kapazität infolge des Abschirmeffektes durch die Einzelelektroden 18 und 20 sowie die Abschirmelektrode 16 deutlich gegenüber einer direkten Kapazität verringert.

Zur Messung der Kapazitätsänderung ist zwischen der Signalleitung 26 und dem Erdpotenzial eine Auswerteschaltung 33 angeordnet. Diese Auswerteschaltung 33 detektiert das Verhältnis aus Kapazitätsänderung ΔC zur Kapazität C. Da die Kapazität C gering ist, kann eine kleine Kapazitätsänderung ΔC detektiert werden. Zur Detektion der Kapazität kann entweder eine Messbrücke verwendet oder die Ladekonstante beobachtet werden. Auch sind hierfür bereits vorgefertigte käuflich erwerbbare Elektronikbausteine einsetzbar.

Etwa mittig ist an der Auflagefläche des Sensorkörpers des Einklemmsensors 13 ein Drucksensor 34' angeordnet. Der Drucksensor 34' ist dabei als ein piezoelektrischer Sensor verwirklicht, der bei Druckbeaufschlagung eine messbare Piezospannung generiert. Wird ein im Stellweg befindliches Hindernis von dem Stellelement gegen den Einklemmsensor 13 physisch kontaktiert, so resultiert hieraus eine Verformung des Drucksensors 34', was die mit dem Drucksensor 34' verbundene Auswerteschaltung 33 infolge eines geänderten Ausgabesignales erkennt. Somit erfolgen die berührungslose Detektion eines Hindernisses und die Detektion eines physischen Kontaktes mit dem Hindernis in dem dargestellten Einklemmsensor 13 voneinander völlig unabhängig. Um eine Verformung des Drucksensors 34' zu ermöglichen, ist der Drucksensor in ein Isolationsmaterial 24' eingebettet, welches gegenüber dem Isolationsmaterial 24 eine geringere Härte aufweist. Insbesondere ist das Isolationsmaterial 24'ein EPDM, d.h. ein Ethylen-Propylen-Dien-Kautschuk.

In Fig. 2b ist der in Fig. 2 im Querschnitt gezeigte Einklemmsensor 13 mit einer alternativen Anordnung eines Drucksensors 34 in einer Aufsicht dargestellt. Man erkennt hierbei die flexible Leiterkarte 14, die sich leicht entlang einer Kontur eines Kraftfahrzeugs, wie insbesondere entlang der Kontur einer Schließkante des Rahmens eines Stellelements, führen lässt. Zur Verdeutlichung des Aufbaus ist auf der Oberseite des Einklemmsensors 13 das Isolationsmaterial entfernt bzw. nicht eingezeichnet. Aus diesem Grund sind die in Längsrichtung der flexiblen Leiterkarte 14 unterbrochenen Einzelelektroden 35 deutlich sichtbar. Jede dieser Einzelelektroden 35 weist eine Durchkontaktierung 21 auf, die mit einer separaten Zuleitung verbunden ist. Auf diese Weise ist zur Auswertung des Einklemmsensors 13 ein Multiplex-Verfahren anwendbar. Mit dem in Fig. 2 dargestellten Signalgenerator 28 und der Auswerteschaltung 33 werden zeitlich versetzt nacheinander die Einzelelektroden 35 einzeln angesteuert und die hierdurch gebildeten Kapazitäten jeweils erfasst. Aufgrund der verringerten Fläche der Einzelelektroden 35 gegenüber einer durchgängig verlaufenden Leiterbahn ist die Kapazität zwischen den Elektroden 35 und der Gegenelektrode 25 weiter verringert. Dies erlaubt eine weitere Erhöhung der Detektionsempfindlichkeit.

Auf der Oberfläche des Einklemmsensors 13 ist weiter, in Längsrichtung verlaufend, ein optischer Drucksensor 34 angeordnet, bei dem die Übertragungscharakteristik eines durcheilenden Lichtstrahls druckabhängig ausgestaltet ist. Hierzu wird beispielsweise ein Lichtwellenleiter eingesetzt, bei dessen Verformung sich für einen durcheilenden Lichtstrahl das Verhältnis aus Reflexion und Transmission ändert. Ein physischer Kontakt eines Hindernisses mit dem Drucksensor 34 wird als Änderung der Übertragungscharakteristik eines durchlaufenden Lichtstrahls von einem Ende des Einklemmsensors 13 zu seinem anderen Ende detektiert.

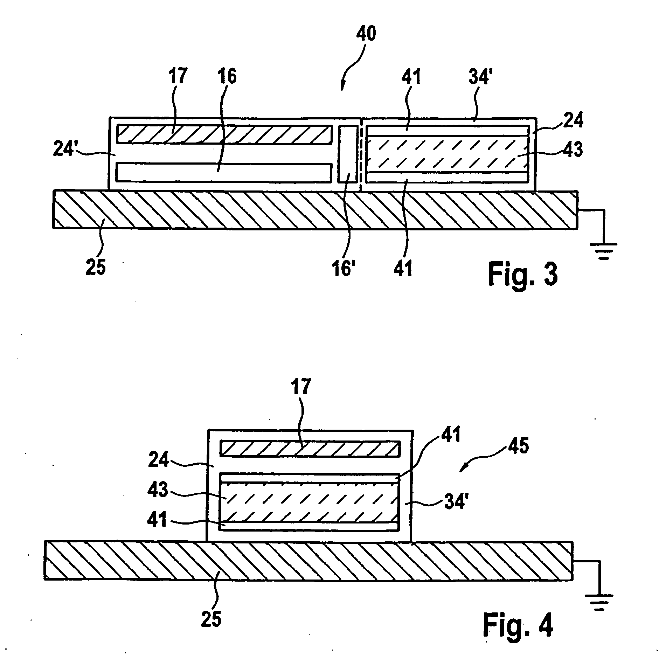

In Fig. 3 ist in einem Querschnitt ein weiterer Einklemmsensor 40 dargestellt, der als ein Flachbandkabel ausgestaltet ist. Der in Fig. 3 dargestellte Einklemmsensor 40 umfasst im Wesentlichen zwei Subsysteme, die der berührungslosen Detektion eines Hindernisses bzw. der Detektion eines physischen Kontaktes mit einem Hindernis dienen. Dabei ist das erste Subsystem zur berührungslosen Detektion eines Hindernisses durch eine als Flachleiter ausgebildete Messelektrode 17 und durch die ebenfalls als Flachleiter ausgebildeten Abschirmelektroden 16 und 16' ausgebildet. Die Messelektrode 17 des Einklemmsensors 40 gemäß Fig.3 ist dabei im Unterschied zur Fig. 2 nicht segmentiert.

Wie vorbeschrieben wird durch Anlegen eines Messpotenzials an die Messelektrode 17 und Anlegen eines identischen Potenzials an die Abschirmelektroden 16 und 16' erreicht, dass sich zwischen der Messelektrode 17 und der geerdeten Karosserie 25 ein in den Raum hineinragendes elektrisches Feld ausgebildet wird. Somit kann ein in das elektrische Feld eindringendes dielektrisches Hindernis als eine Kapazitätsänderung der Kapazität zwischen Messelektrode 17 und Abschirmelektroden 16 und 16' erkannt werden.

Das Isolationsmaterial 24' im Bereich des ersten Subsystems, d.h. im Bereich der Elektroden 16 und 17, ist als ein Epoxidharz ausgeführt, so dass eine Druckbeaufschlagung zu keiner Änderung des Abstands zwischen der Messelektrode 17 und der Gegenelektrode 25 führt.

Als weiteres Subsystem ist in das Isolationsmaterial 24 des Sensorkörpers ein piezokeramischer Drucksensor 34' integriert. Der piezokeramische Drucksensor 34' umfasst hierbei eine zwischen äußeren Elektroden 41 angeordnete Piezokeramik 43. Das Isolationsmaterial 24 ist im Bereich des piezokeramischen Drucksensors 34' als Silikonkautschuk oder als EPDM ausgeführt. Eine äußere Druckeinwirkung auf den Einklemmsensor 40 resultiert über das elastische Isolationsmaterial 24 in einer Verformung der Piezokeramik 43. Hieraus resultiert eine piezoelektrische Spannung, die über die Elektroden 41 abgegriffen werden kann.

In Fig. 4 ist ein als Flachbandkabel ausgeführter erfingdungsgemäßer Einklemmsensor 45 gezeigt. Im dargestellten Fall ist das Isolationsmaterial 24, in welches eine Messelektrode 17 eingebettet ist, insgesamt elastisch ausgeführt. Unterhalb der Messelektrode 17 befindet sich ein piezokeramischer Drucksensor 34', der eine zwischen flächigen Elektroden 41 angeordnete Piezokeramik 43 umfasst.

Die Elektroden 41 des piezokeramischen Drucksensors 34' werden wie in Fig. 2 dargestellt, als Abschirmelektroden eingesetzt und mit demselben Messpotenzial beaufschlagt wie die Messelektrode 17. Hierdurch erfüllt der piezokeramische Drucksensor 34' die Funktion einer Abschirmelektrode, so dass sich ein gewünschtes äußeres elektrisches Feld zwischen der mit dem Messpotenzial beaufschlagten Messelektrode 17 und der Gegenelektrode 25 bzw. der Fahrzeugkarosserie ausbildet. Somit kann ein kompakter Aufbau des Einklemmsensors 45 erzielt werden.

In Längsrichtung des Einklemmsensors 45 ist sowohl die Messelektrode 17 als auch der piezokeramische Drucksensor 34' jeweils in gleich lange Abschnitte segmentiert. Hierzu ist die Messelektrode 17 in Einzelelektroden unterteilt. Der piezokeramische Drucksensor 34' umfasst hierzu eine Reihe von einzeln auslesbaren druckempfindlichen Einzelsensoren. Eine solche Anordnung erlaubt eine räumliche Auflösung eines Einklemmfalles und erlaubt es auch, für die Detektion eines Einklemmfalles in unterschiedlichen Segmenten des Einklemmsensors 45 die Signale einer Kapazitätsänderung (berührungslose Detektion) und eines infolge physischen Kontaktes auslösenden Drucksensors 36 unterschiedlich zu berücksichtigen bzw. zu priorisieren.

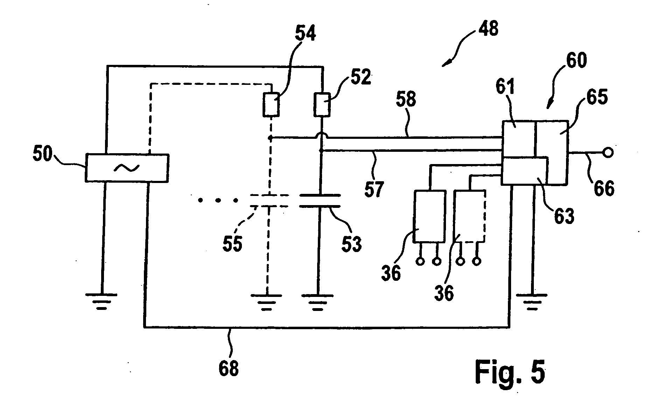

In Fig. 5 ist schematisch eine Auswerteschaltung 48 zur Ansteuerung eines der vorgenannten Einklemmsensoren gezeigt. Die Auswerteschaltung 48 umfasst hierbei eine steuerbare Wechselspannungsquelle 50, sowie Messbrücken, die jeweils aus einem Vorwiderstand 52,54 und der jeweils zu messenden Messkapazität 53 bzw. 55 aufgebaut sind. Mittels der Messbrücken werden die Messkapazitäten 53,55 über zugeordnete Signalabgriffe 57 bzw. 58 mittels einer Auswerteeinheit 60 erfasst. Hierzu weist die Auswerteeinheit 60 Kapazitätsauswertemittel 61 auf, die mittels einer Vergleichsspannung die an der jeweiligen Messkapazität 53 bzw. 55 abfallende Spannung bestimmt und hieraus die Größe der Messkapazität 53 bzw. 55 ermittelt. Hierzu wird die Wechselspannungsquelle 50 jeweils zur Ausgabe einer entsprechenden Wechselspannung an die der zu bestimmenden Messkapazität 53,55 entsprechende Messelektrode angesteuert.

Weiter umfasst die Auswerteeinheit 60 Sensorauswertemittel 63, die zum einen zeitliche Änderungen der Messkapazitäten 53,55 und zum anderen Sensorsignale von zugeordneten druckempfindlichen Einzelsensoren 36 auswertet. Sowohl bei einer entsprechenden zeitlichen Änderung der Messkapazitäten 53,55 als auch bei einem entsprechenden Sensorsignal der Drucksensoren 36 kommunizieren die Sensorauswertemittel 63 mit Ausgabemitteln 65 derart, dass ein entsprechendes Detektionssignal am Detektionsausgang 66 erzeugt wird. In Abhängigkeit von dem Detektionssignal wird mittels einer entsprechenden Motorsteuerung der Antrieb eines Stellelements gestoppt und reversierend angetrieben.

Die Sensorauswertemittel 63 können auch derart eingerichtet sein, dass beispielsweise für einen Einklemmsensor gemäß Fig. 4 die Ausgabe eines Detektionssignals in unterschiedlichen Segmenten des Einklemmsensors unterschiedlich von der Detektion einer zeitlichen Änderung der jeweiligen Messkapazität 53,55 und den jeweils von den Einzelsensoren ausgegebenen Drucksignalen abhängig ist. So kann beispielsweise in einem vorbestimmten Segment im Zusammenspiel zwischen den Sensorauswertemitteln 63 und den Ausgabemitteln 65 ein Detektionssignal am Detektionsausgang 66 nur dann erzeugt werden, wenn ein entsprechendes Signal des jeweiligen Drucksensors 36 vorliegt. In anderen Segmenten kann wiederum die Kapazitätsänderung der jeweiligen Messkapazitäten 53,55 zu der Erzeugung eines Detektionssignals am Detektionsausgang 66 führen, während die Drucksensoren 36 unberücksichtigt bleiben.

### Bezugszeichenliste

- 1: Kraftfahrzeug
- 2: Motorhaube
- 3: Dach
- 4: Windschutzscheibe
- 5: Tür, vorne
- 6: Tür, hinten
- 7: Stellelement
- 9: Scheibe
- 10: Einklemmsensor
- 11: Dichtelement
- 13: Einklemmsensor
- 14: Leiterkarte
- 16,16': Abschirmelektrode
- 17: Messelektrode
- 18: Einzelelektrode (Abschirmung)
- 20: Einzelelektrode (Abschirmung)
- 21: Durchkontaktierung
- 23: Zuleitungen
- 24: Isolationsmaterial
- 25: Gegenelektrode
- 26: Signalleitung
- 28: Signalgenerator
- 30: Verbindungsleitung
- 32: Schaltmittel
- 33: Auswerteschaltung
- 34,34': Drucksensor
- 35: Einzelelektroden (Messelektrode)
- 36: Einzelsensoren (Druck)
- 40: Einklemmsensor
- 41: Elektroden (Drucksensor)
- 43: Piezokeramik
- 45: Einklemmsensor
- 48: Auswerteschaltung
- 50: Wechselspannungsquelle
- 52: Ohmscher Widerstand
- 53: Messkapazität
- 54: Ohmscher Widerstand
- 55: Messkapazität
- 57: Signalabgriff
- 58: Signalabgriff
- 60: Auswerteeinheit
- 61: Kapazitätsauswertemittel
- 63: Sensorauswertemittel
- 65: Ausgabemittel
- 66: Detektionsausgang
- 68: Steuerleitung

## Patentansprüche

1. Einklemmsensor (10,13,40,45), insbesondere zum Erkennen eines Hindernisses im Weg eines Stellelements (z.B. 9) eines Kraftfahrzeugs (1), mit einem Sensorkörper, der eine Messelektrode (17) zur Erzeugung eines äußeren elektrischen Feldes gegenüber einer Gegenelektrode (25) und einen Drucksensor (34,34') mit Elektroden (41) zu einer von der Messelektrode (17) entkoppelten Detektion eines mechanischen Druckes umfasst,
**dadurch gekennzeichnet,**
**dass** eine Elektrode (41) des Drucksensors (34,34') als Abschirmelektrode (16) eines Driven-Shield eingesetzt ist, die mittels Schaltmittel auf das Potenzial der Messelektrode (17) gebracht ist.

2. Einklemmsensor (10,13,40,45) nach Anspruch 1,
**dadurch gekennzeichnet,**
**dass** der Sensorkörper einen Drucksensorteil aus einem flexiblen, insbesondere elastischen Material und einen Messelektrodenteil aus einem Material höherer Härte umfasst.

3. Einklemmsensor (10,13,40,45) nach Anspruch 1 oder 2,
**dadurch gekennzeichnet,**
**dass** der Drucksensor (34,34') als ein Kontaktelement an einer Auflagefläche des Sensorkörpers angeordnet ist.

4. Einklemmsensor (10,13,40,45) nach einem der vorhergehenden Ansprüche,
**dadurch gekennzeichnet,**
**dass** die als Driven-Shield ausgebildete Abschirmelektrode (16,16') zur Richtung des elektrischen Feldes in einen Gefährdungsbereich angeordnet ist.

5. Einklemmsensor (10,13,40,45) nach einem der vorhergehenden Ansprüche,
**dadurch gekennzeichnet,**
**dass** die Abschirmelektrode (16) in elektrisch kontaktierbare Einzelelektroden (18,20) unterteilt ist, zwischen denen isoliert die separaten Zuleitungen (23) angeordnet sind.

6. Einklemmsensor nach einem der vorhergehenden Ansprüche,
**dadurch gekennzeichnet,**
**dass** der Drucksensor (34,34') als ein piezoelektrischer Drucksensor (34') aufgebaut ist.

7. Einklemmsensor (10,13,40,45) nach einem der Ansprüche 2 bis 6,
**dadurch gekennzeichnet,**
**dass** der Sensorkörper als eine flexible Leiterstruktur (14) ausgeführt ist.

8. Baueinheit, umfassend einen Einklemmsensor (10,13,40,45) gemäß einem der vorhergehenden Ansprüche sowie eine Auswerteschaltung (33,48) mit Messpotentialausgabemitteln zur Ausgabe eines Messpotentials an eine Messelektrode (17), mit Kapazitätserfassungsmitteln zur Erfassung einer von einer Gegenelektrode (25) und einer Messelektrode (17) gebildeten Messkapazität, mit Kapazitätsauswertemitteln (61) zur Auswertung einer Änderung der erfassten Messkapazität, mit Sensorauswertemitteln (63) zur unabhängigen Erfassung und Auswertung von Signalen eines Drucksensors (34,34'), und mit Ausgabemitteln (65) zur Ausgabe eines Detektionssignals in Abhängigkeit von der zeitlichen Änderung der Messkapazität und eines Detektionssignals in Abhängigkeit von dem ausgewerteten Signal des Drucksensors (34,34').

9. Baueinheit nach Anspruch 8,
wobei die Kapazitätsauswertemittel (61) zur Auswertung einer zeitlichen Änderung der Messkapazität ausgebildet sind.

10. Baueinheit nach Anspruch 8 oder 9,
wobei die Kapazitätserfassungs- und auswertemittel (61) und/oder die Sensorauswertemittel (63) zur selektiven Auswertung von in Segmenten angeordneten Einzelelektroden (35) und/oder Einzelsensoren (36) ausgebildet sind.

11. Baueinheit nach Anspruch 10,
wobei die Ausgabemittel (65) ausgelegt sind, zur Ausgabe des Detektionssignals die Signale der Einzelelektroden (35) und der Einzelsensoren (36) in unterschiedlichen Segmenten unterschiedlich zu priorisieren.

12. Baueinheit nach einem der Ansprüche 9 bis 11,
mit Selektivfiltern für die Signale der Messkapazitäten und/oder der Signale des Drucksensors (34,34').

## Claims

1. Anti-pinch sensor (10, 13, 40, 45), in particular for identifying an obstacle in the path of an actuating element (for example 9) of a motor vehicle (1), having a sensor body which comprises a measurement electrode (17) for generating an external electric field relative to a mating electrode (25) and comprises a pressure sensor (34, 34') having electrodes (41) for detecting a mechanical pressure in a manner decoupled from the measurement electrode (17), **characterized in that** an electrode (41) of the pressure sensor (34, 34') is used as a shielding electrode (16) of a driven shield, which shielding electrode is connected to the potential of the measurement electrode (17) by means of switching means.

2. Anti-pinch sensor (10, 13, 40, 45) according to Claim 1, **characterized in that** the sensor body comprises a pressure sensor part comprising a flexible, in particular elastic, material, and a measurement electrode part comprising a material of relatively high hardness.

3. Anti-pinch sensor (10, 13, 40, 45) according to Claim 1 or 2, **characterized in that** the pressure sensor (34, 34'), in the form of a contact element, is arranged on a bearing face of the sensor body.

4. Anti-pinch sensor (10, 13, 40, 45) according to one of the preceding claims, **characterized in that** the shielding electrode (16, 16'), which is in the form of a driven shield, is arranged facing the direction of the electric field in a hazard region.

5. Anti-pinch sensor (10, 13, 40, 45) according to one of the preceding claims, **characterized in that** the shielding electrode (16) is divided into individual electrodes (18, 20) with which electrical contact can be made and between which the separate supply lines (23) are arranged in an insulated manner.

6. Anti-pinch sensor according to one of the preceding claims, **characterized in that** the pressure sensor (34, 34') is formed as a piezoelectric pressure sensor (34').

7. Anti-pinch sensor (10, 13, 40, 45) according to one of Claims 2 to 6, **characterized in that** the sensor body is designed as a flexible conductor structure (14).

8. Unit comprising an anti-pinch sensor (10, 13, 40, 45) according to one of the preceding claims and an evaluation circuit (33, 48) having measurement potential output means for outputting a measurement potential to a measurement electrode (17), having capacitance recording means for recording a measurement capacitance which is formed by a mating electrode (25) and a measurement electrode (17), having capacitance evaluation means (61) for evaluating a change in the detected measurement capacitance, having sensor evaluation means (63) for independently recording and evaluating signals from a pressure sensor (34, 34'), and having output means (65) for outputting a detection signal as a function of the change in the measurement capacitance over time and a detection signal as a function of the evaluated signal from the pressure sensor (34, 34').

9. Unit according to Claim 8, with the capacitance evaluation means (61) being designed to evaluate a change in the measurement capacitance over time.

10. Unit according to Claim 8 or 9, with the capacitance detection and evaluation means (61) and/or the sensor evaluation means (63) being designed for selectively evaluating individual electrodes (35) which are arranged in segments and/or individual sensors (36).

11. Unit according to Claim 10, with the output means (65) being designed, for the purpose of outputting the detection signal, to prioritize the signals from the individual electrodes (35) and the individual sensors (36) differently in different segments.

12. Unit according to one of Claims 9 to 11, having selective filters for the signals from the measurement capacitors and/or the signals from the pressure sensor (34, 34').

## Revendications

1. Détecteur anti-pincement (10, 13, 40, 45), notamment destiné à reconnaître un obstacle dans le parcours de déplacement d'un élément déplaçable ou réglable (par exemple 9) d'un véhicule automobile (1), comportant un corps de détecteur, qui comprend une électrode de mesure (17) pour engendrer un champ électrique extérieur par rapport à une électrode conjuguée (25), et un détecteur de pression (34, 34') comportant des électrodes (41) pour la détection, découplée de l'électrode de mesure (17), d'une pression mécanique,
**caractérisé en ce qu'**une électrode (41) du détecteur de pression (34, 34') est mise en oeuvre en tant qu'électrode de blindage (16) d'un écran commandé (driven shield), à laquelle est appliqué le potentiel de l'électrode de mesure (17) via des moyens de commutation.

2. Détecteur anti-pincement (10, 13, 40, 45) selon la revendication 1,
**caractérisé en ce que** le corps de détecteur comprend une partie de détecteur de pression en un matériau flexible, notamment élastique, et une partie d'électrode de mesure en un matériau de dureté plus élevée.

3. Détecteur anti-pincement (10, 13, 40, 45) selon la revendication 1 ou la revendication 2,
**caractérisé en ce que** le détecteur de pression (34, 34') est agencé en tant qu'élément de contact sur une surface d'appui du corps de détecteur.

4. Détecteur anti-pincement (10, 13, 40, 45) selon l'une des revendications précédentes,
**caractérisé en ce que** l'électrode de blindage (16, 16') configurée en tant qu'écran commandé (driven shield) est agencée pour diriger le champ électrique dans une zone potentielle de danger.

5. Détecteur anti-pincement (10, 13, 40, 45) selon l'une des revendications précédentes,
**caractérisé en ce que** l'électrode de blindage (16) est subdivisée en électrodes individuelles (18, 20) pouvant être contactées électriquement, et entre lesquelles sont agencés de manière isolée, les conducteurs d'alimentation (23) séparés.

6. Détecteur anti-pincement selon l'une des revendications précédentes,
**caractérisé en ce que** le détecteur de pression (34, 34') est construit comme un détecteur de pression du type piézoélectrique (34').

7. Détecteur anti-pincement (10, 13, 40, 45) selon l'une des revendications 2 à 6,
**caractérisé en ce que** le corps de détecteur est réalisé en tant que structure conductrice flexible (14).

8. Module de construction mécanique englobant un détecteur anti-pincement (10, 13, 40, 45) selon l'une des revendications précédentes, ainsi qu'un circuit de traitement d'exploitation de données (33, 48) comprenant des moyens de fourniture de potentiel de mesure pour fournir un potentiel de mesure à une électrode de mesure (17), comprenant des moyens de relevé de capacité destinés à relever une capacité de mesure formée par une électrode conjuguée (25) et une électrode de mesure (17), comprenant des moyens de traitement d'exploitation de données de capacité (61) pour traiter une variation de la capacité de mesure relevée, comprenant des moyens de traitement d'exploitation de données de détecteur (63) pour le relevé indépendant et le traitement d'exploitation de signaux d'un détecteur de pression (34, 34'), et comprenant des moyens de délivrance (65) pour délivrer un signal de détection en fonction de la variation dans le temps de la capacité de mesure, et un signal de détection en fonction du signal traité du détecteur de pression (34, 34').

9. Module de construction mécanique selon la revendication 8,
dans lequel les moyens de traitement d'exploitation de données de capacité (61) sont réalisés pour traiter une variation dans le temps de la capacité de mesure.

10. Module de construction mécanique selon la revendication 8 ou la revendication 9,
dans lequel les moyens de relevé et de traitement d'exploitation de données de capacité (61) et/ou les moyens de traitement d'exploitation de données de détecteur (63) sont réalisés pour le traitement sélectif de données d'électrodes individuelles (35) et/ou de détecteurs individuels (36) agencés en segments.

11. Module de construction mécanique selon la revendication 10,
dans lequel les moyens de délivrance (65) sont configurés, en vue de délivrer le signal de détection, de manière à prioriser de façon différente les signaux des électrodes individuelles (35) et des détecteurs individuels (36) dans des segments différents.

12. Module de construction mécanique selon l'une des revendications 9 à 11,
comprenant des filtres sélectifs pour les signaux des capacités de mesure et/ou des signaux du détecteur de pression (34, 34').
